# EUROPÄISCHE PATENTSCHRIFT

(11) **EP 1 229 391 B1**
(45) Veröffentlichungstag und Bekanntmachung des Hinweises auf die Patenterteilung: **02.03.2011**
(21) Anmeldenummer: 01126074.2
(22) Anmeldetag: 02.11.2001
(51) Int. Cl.: G03F 7/24, B65H 5/22, B65H 3/08

(54) **Verfahren und Vorrichtung zur Handhabung einer zu belichtenden Druckplatte**
Process and device for handling a printing plate to be exposed
Procédé et appareil pour la manipulation plaques d'impression à insoler

(30) Priorität: 01.02.2001 DE 10104415
(43) Veröffentlichungstag der Anmeldung: 07.08.2002
(73) Patentinhaber: Heidelberger Druckmaschinen Aktiengesellschaft, 69115 Heidelberg (DE)
(72) Erfinder: Behrens, Gunnar, 24111 Kiel (DE); Lassen, Bernd, 24248 Mönkeberg (DE)

(56) Entgegenhaltungen:
- EP-A1- 0 994 366
- EP-A2- 0 887 181
- DE-A1- 4 038 544
- JP-A- 10 273 242
- JP-A- 11 338 165
- US-A- 6 042 101

## Beschreibung

Die Erfindung betrifft ein Verfahren zur Handhabung einer Druckplatte beim Einbringen in den Belichtungsbereich einer Belichtungseinheit und/oder beim Ausbringen aus einer Belichtungseinheit eines Druckplattenbelichters, insbesondere eines Innentrommel-Druckplattenbelichters.

Des weiteren betrifft die Erfindung einen Druckplattenbelichter zur Durchführung des Verfahrens mit einer Vorrichtung zur Handhabung einer zu belichtenden Druckplatte, beim Einbringen in den Belichtungsbereich einer Belichtungseinheit und/oder beim Ausbringen aus einer Belichtungseinheit des Druckplattenbelichters.

Bei der zu belichtenden Druckplatte ist es egal, ob es sich um eine metallische Druckplatte oder um eine Druckplatte aus Kunststoff, bspw. aus Polyester, handelt. Die Art der Belichtung spielt prinzipiell ebenfalls keine Rolle. Es kann sich also beispielsweise um eine Belichtung mit sichtbarem Licht, eine Belichtung mit ultraviolettem Licht oder auch eine thermische Belichtung mit hochenergetischem Licht im Ablationsverfahren handeln.

Für die Belichtung muß die zu belichtende Druckplatte in den Belichtungsbereich der Belichtungseinheit einer Belichtungsvorrichtung, also eines Plattenbelichters, eingebracht werden und nach dem Belichtungsvorgang wieder aus der Belichtungseinheit ausgebracht werden. Es werden insbesondere drei Arten von Belichtern bezüglich ihrer Geometrie in der Belichtungseinheit voneinander unterschieden, nämlich Innentrommelbelichter mit einem muldenförmigen Belichtungsbereich, in den die Druckplatte eingeführt werden muß, Außentrommelbelichter, auf deren Trommelaußenseite die Druckplatte aufgespannt wird, und Flachbettbelichter, in die die Druckplatte ungekrümmt, flach eingebracht wird.

Bei allen drei Arten von Belichtern wird die zu belichtende Druckplatte üblicherweise aus einem Zuführungsbereich eingeführt und nach der Belichtung in einen Abführungsbereich ausgeführt, wobei für diese Führung und den Transport Transport- und Umlenkwalzen, Förderbänder, Riemen, Rollen, Leitbleche oder dergleichen Elemente und Organe verwendet werden. Bei einer solchen Handhabung werden die Druckplatten jedoch selbst mechanisch sehr beansprucht. Insbesondere kann es dabei auch zu Beschädigungen auf der zu belichtenden Vorderseite in dem zu belichtenden Feld der zu belichtenden Druckplatte kommen, wodurch das durch die Belichtung gewünschte Ergebnis bis zur Unbrauchbarkeit beeinträchtigt werden kann.

Der Erfindung liegt daher die Aufgabe zugrunde, ein Verfahren bzw. eine Vorrichtung der eingangs genannten Gattung im Hinblick darauf aufzuzeigen, daß die Druckplatte schonender gehandhabt wird, vorzugsweise zudem aber auch ein zuverlässiger reproduzierbarer und automatisierbarer und letztlich auch präziserer Handhabungsablauf verwirklicht wird.

Diese Aufgabe wird erfindungsgemäß in Verfahrenshinsicht nach Anspruch 1 dadurch gelöst, dass die Druckplatte hängend abgesenkt wird.

Eine Druckplatte muß nur in einem oberen Randbereich gehalten werden, der außerhalb des zu belichtenden Feldes der Vorderseite der Druckplatte liegen kann, während in übrigen Bereichen der Druckplatte Kontakte vermieden werden können. Insbesondere kann also erfindungsgemäß die beispielsweise auf ihrer Rückseite liegende Druckplatte mit Vorteil in eine hängende Position aufgenommen werden und in den Bereich der Belichtungseinheit abgelegt, bspw. in eine Mulde einer Innentrommel abgetaucht werden, wo sie wiederum unmittelbar mit ihrer Rückseite Kontakt zur Belichtungseinheit bekommt, ohne daß dazwischen anderweitige Führungselemente oder Transportorgane die Druckplatte kontaktieren müssen. Vor allem der zu belichtende Feldbereich bleibt dadurch mit Vorteil völlig geschützt.

Die zu belichtende Druckplatte kann somit vorzugsweise aus einer etwa waagerechten Orientierung in einem Zuführungsbereich oder Ladebereich, bspw. von einer Art Tischplatte oder aus einem Magazin, in eine hängende Orientierung überführt werden und zur Einbringung in die Belichtungseinheit abgesenkt werden. Nach der Belichtung kann sie insbesondere vorzugsweise auf demselben oder einem anderen Weg zurück oder in einen anderen Abführungsbereich abgeführt werden.

Zum Anheben in die hängende Position wird die Druckplatte, wie bereits kurz erwähnt, nur in einem Randbereich erfaßt und hochgezogen. Dies kann reibungsvermindert und auch schonend für die Rückseite der Druckplatte auf einem Luftpolster erfolgen, das mit zugeführter Luft erzeugt werden kann.

Wenn die Druckplatte dann vor einer Absenkung in die Belichtungseinheit ihre hängende Position erreicht hat, kann umgekehrt eine Luftabsaugung unter bzw. hinter der Rückseite der Druckplatte erfolgen, um eine gewisse Anhaftung der Druckplatte auf einer Führung zu erreichen, so daß die Druckplatte noch leicht bewegt werden kann, aber durch eine Anlage geführt ist und präziser bewegt werden kann, insbesondere ohne daß sie aufbeult, ausschert oder verkantet. In der Belichtungsposition wird die Druckplatte während der Belichtung vorzugsweise durch (stärkere) Luftansaugung in der Belichtungseinheit unverrutschbar fixiert.

Zusätzlich kann die Druckplatte im Zuführungs- bzw. Abführungsbereich und/oder im Belichtungsbereich ausgerichtet werden, beispielsweise durch einfache Leitflächen.

Eine weitere Weiterbildung des erfindungsgemäßen Verfahrens sieht vor, daß die Druckplatte nach dem Belichtungsvorgang im fixierten Zustand gestanzt wird.

Ein erfindungsgemäßer Druckplattenbelichter mit einer Vorrichtung der eingangs genannten Gattung zeichnet sich in selbständiger Lösung der gestellten Aufgabe aus durch eine Aufhängeeinrichtung für die Druckplatte. Dadurch kann eine hängende (Übergangs) Position der Druckplatte ermöglicht werden, deren Vorteile schon im Zusammenhang mit dem erfindungsgemäßen Verfahren geschildert worden sind. Dafür umfaßt die erfindungsgemäße Vorrichtung vorzugsweise eine Hub-Senkeinrich-tung für die zu belichtende Druckplatte.

Eine andere Weiterbildung der erfindungsgemäßen Vorrichtung sieht zudem vor, daß die Aufhängeeinrichtung wenigstens einen Greifer zum randseitigen Erfassen bzw. Umklammern der Druckplatte aufweist. Damit kann die Druckplatte unter größtmöglicher Schonung, insbesondere des belichtungswirksamen Bereiches, erfaßt und angehoben werden.

Zur Führung der Hub-Senkeinrichtung und der zu belichtenden Druckplatte selbst, weist die Aufhängeeinrichtung bevorzugt einen sich etwa lotrecht erstreckenden Ladebaum auf, der insbesondere auch raumsparend ist.

Eine nächste Weiterbildung der Erfindung sieht mit Vorteil vor, daß mit der Aufhängeeinrichtung selbst unmittelbar auf einen Zuführungsbereich für zu belichtende Druckplatten zugegriffen werden kann. Der Zuführungsbereich kann zum Beispiel eine etwa waagerecht ausgerichtete Tischplatte umfassen, er kann aber zum Beispiel auch ein vorzugsweise auswechselbares und andockbares Magazin umfassen, mit dem eine größere Anzahl von Druckplatten in den Zuführungsbereich eingebracht werden kann. Ein Magazinhandling ist insbesondere dann angezeigt, wenn mit Druckplatten gearbeitet wird, die tageslichtempfindlich sind, weil sie auf diese Weise lichtgeschützt in den Belichter eingebracht und eventuell gleichartig auch wieder ausgebracht werden können. Insbesondere ist der Nachladevorgang des Belichters damit durch die Erfindung auch insgesamt automatisierbar und die Auslastung des Belichters ökonomischer.

Für den Arbeitsablauf vorteilhaft, ist der Eintritts- bzw. Einführungsbereich zur Belichtungseinheit unterhalb der Aufhängeeinrichtung angeordnet, so daß die Druckplatte hängend abgesenkt und geleitet in die Belichtungsposition verbracht werden kann.

Eine bevorzugt vorgesehene Wegeweiche sorgt dafür, daß die Druckplatte wahlweise aus der hängenden Position in die Belichtungseinrichtung oder in den Abführungsbereich gelangt, der mit dem Zuführungsbereich zusammenfallen kann.

Eine Ausrichtungseinrichtung sorgt vorzugsweise für die Ausrichtung der Druckplatte, und zwar bevorzugt jeweils in jedem jeweiligen Bereich. So kann die Ausrichtungseinrichtung im Zuführungs- und im Abführungsbereich Leitflächen aufweisen, um die Druckplatte dort in Querrichtung auszurichten, und es können beispielsweise im Belichtungsbereich Gleitsteine in Nuten geführt sein, um die Druckplatte in Richtung ihres Weges zu verschieben und auszurichten bzw. zu positionieren.

Nach einer nächsten Weiterbildung der Erfindung weist die Vorrichtung wenigstens eine Luftgebläse- und/oder -saugeinrichtung zur Vorgabe eines Gleitens und/oder Haftens der Druckplatte in wenigstens einem Bereich der Vorrichtung auf, mit der zum Beispiel, abhängig von der Luftstromstärke und -richtung, beim Hochziehen die Druckplatte auf einem Luftpolster gleiten kann, beim Absenken durch leichte Luftansaugung leicht haftend geführt werden kann und nach dem Positionieren in der Belichtungseinrichtung durch stärkere Luftansaugung fixiert werden kann.

Außerdem ist bevorzugt eine Stanze zum Stanzen der Druckplatte am Ausgang der Belichtungseinheit als Bestandteil der erfindungsgemäßen Vorrichtung vorgesehen, mit der die Druckplatte nach der Belichtung mit Stanzausnehmungen versehen werden kann. Dies dient zu einem Positionieren oder Einspannen der Druckplatte in einem nachfolgenden Gerät. Erfindungsgemäß ist die Stanze am Ausgang der Belichtungseinheit angeordnet, also an einer Stelle, die von jeder Druckplatte nach der Belichtung passiert werden muß und also in jedem Falle erreicht wird, unabhängig von dem jeweiligen Format der Druckplatte.

Die erfindungsgemäße Vorrichtung ist besonders vorteilhaft als Bestandteil oder in unmittelbarer Verbindung mit einem Druckplattenbelichter, weil relativ steife und dennoch hinreichend flexible Druckplatten aus beliebigem geeigneten Werkstoff sich besonders gut, präzise, ökonomisch und fortlaufend mit einem hohen Durchsatz und Automatisierungsgrad mit der erfindungsgemäßen Vorrichtung handhaben lassen.

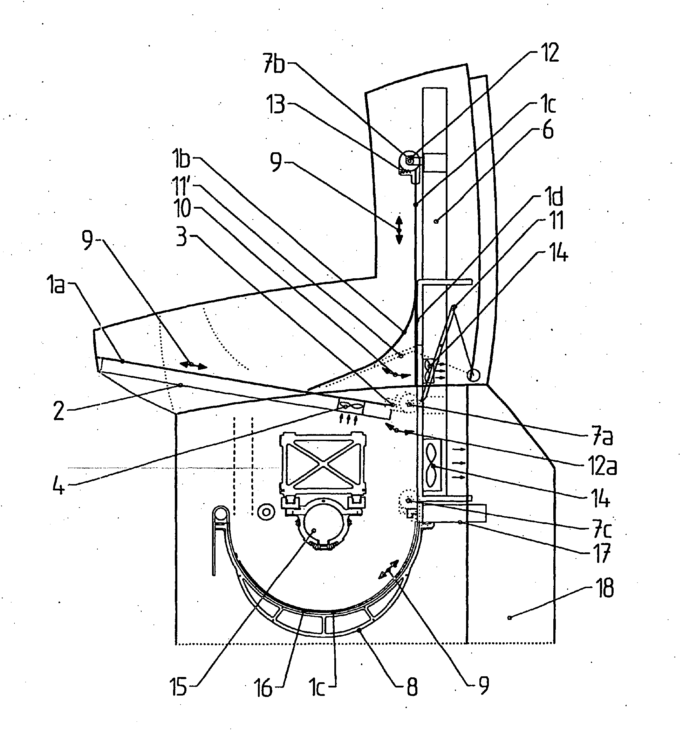

Ein Ausführungsbeispiel der Erfindung, aus dem sich weitere erfinderische Merkmale entnehmen lassen, auf das die Erfindung aber nicht in ihrem Umfang beschränkt ist, ist in der einzigen Zeichnungsfigur dargestellt.

Die Figur zeigt eine erfindungsgemäße Vorrichtung in einem schematischen Querschnitt entlang des Weges einer zu belichtenden Druckplatte durch die Vorrichtung, wobei beispielhaft eine Kantenansicht einer Druckplatte in verschiedenen ausgewählten Positionen in der Zeichnung angedeutet ist und so den Bewegungsablauf in der Vorrichtung verdeutlicht.

Die erfindungsgemäße Vorrichtung ermöglicht in besonders guter Weise die Handhabung von vorzugsweise Offset-Druckplatten vor, während und nach einem Belichtungsvorgang. Dabei können die Druckplatten oder allgemeiner die zu belichtenden Druckplatten unterschiedlichste Formate , Dicken oder Beschichtungen aufweisen und dennoch schonend, schnell und registergenau in einer Innentrommel, auf einer Außentrommel oder auf einem flachen Belichtungstisch einer Belichtungseinheit positioniert werden. Dabei kann die erfindungsgemäße Vorrichtung zudem eine kompakte Bauweise haben, einen geringen "footprint" verursachen, kostengünstig sein und arbeiten, insbesondere durch eine relativ einfache Mechanik mit relativ wenig Bauteilen und durch einfache und übersichtliche Bewegungsabläufe. Gleichzeitig ist eine hohe Funktionssicherheit gewährleistet.

Die Vorrichtung hat keine komplizierten und sperrigen Aufbauten auf der Belichtungseinheit und ist manuell, wie auch vollautomatisch bestückbar bzw. nachladbar. Die Druckplatte wird in ihrem Druckbereich nicht berührt, sondern nur im Bereich bzw. Umfeld einer eventuellen Stanzung gehalten.

Im nachfolgenden werden nun anhand des zeichnerisch nur schematisch und beispielhaft dargestellten Ausführungsbeispieles wesentliche Bau- und Funktionsgruppen einer erfindungsgemäßen Vorrichtung als Bestandteil eines Innentrommel-Druck-plattenbelichters beschrieben.

Der dargestellte Belichter weist als Zuführungsbereich für zu belichtende Druckplatten 1a einen Plattentisch 2 auf, der aus ergonomischen Gründen um etwa 10° in den Belichter hinein geneigt angeordnet ist. Durch diese Neigung rutscht aber eine eingebrachte Druckplatte 1a auch mit Vorteil aufgrund ihrer Schwerkraft selbsttätig in eine gewünscht Zuführungsposition bis an einen Anschlag 3. Mit Hilfe eines Lüfters 4 wird auf der Tischfläche des Plattentisches 2 ein Luftkissen oder Luftpolster unterhalb der Druckplatte 1a erzeugt, so daß sie in diesem Zuführungsbereich reibungsvermindert gleitet.

Das Mittenzentrieren der Druckplatte 1a auf dem Plattentisch 2 geschieht mittels zwei gegenläufig antreibbaren Zentrierschiebern 5. Diese Schiebeeinrichtung geht selbsttätig wieder in ihre Nullstellung zurück. Diese Nullstellung wird durch einen Sensor abgefragt. Das Vorhandensein einer Druckplatte 1a auf dem Plattentisch wird zudem durch einen Plattenanwesenheitssensor ermittelt.

Die Baueinheit mit dem Plattentisch 2 ist selbsttragend ausgebildet und kann, falls gewünscht, komplett entfernt werden, wenn beispielsweise der Belichter zu einem Vollautomaten mit automatischer Plattennachladung aus einem Magazin hochgerüstet werden soll.

Die erfindungsgemäße Vorrichtung umfaßt einen aufragenden Ladebaum 6, an dem eine Greifeinrichtung zur Ergreifung der Druckplatte 1a abgehängt ist, die in der Zeichnung in einer unteren Position mit 7a und in einer oberen Position mit 7b bezeichnet ist. Entsprechend dieser Positionen wird mit der Greifeinrichtung 7a, 7b die Druckplatte 1a über eine Zwischenposition 1b in eine hängende Position 1c hochgezogen. Verschiedene Positionen der Druckplatte in der Vorrichtung sind zur Veranschaulichung ihres Bewegungsablaufes in der Zeichnung dargestellt und jeweils mit der Bezugszahl 1 unter Hinzufügung unterschiedlicher Kleinbuchstaben mit 1a bis 1e bezeichnet.

Der Ladebaum 6 mit seiner Greifeinrichtung 7 hat die Aufgabe , die Druckplatte 1 vom Plattentisch 2 über die hängende Position 1c in eine Belichtungseinheit 8 und auf demselben Weg wieder zurück auf den Plattentisch 2 zu befördern, der im dargestellten Ausführungsbeispiel einer erfindungsgemäßen Vorrichtung auch als Entnahme- oder Abführungsbereich für die fertig belichtete Druckplatte 1 dient. Der Weg der Druckplatte 1 durch die Vorrichtung ist entsprechend seiner beiden Durchlaufrichtungen mit Doppelpfeilen 9 gekennzeichnet. Unterstützt und gesteuert wird der Bewegungsablauf durch eine als Wegeweiche ausgebildete, in Richtung des Doppelpfeiles 10 schwenkbare Druckplattenführung 11, 11'.

Der Ladebaum 6 ist so ausgebildet, daß er unverändert auch in einer vollautomatischen Vorrichtung verwendet werden kann. Er stützt sich im Bereich der Druckplattenführung 11 ab.

Die Greifeinrichtung 7 ist als Greiferleiste ausgebildet, die auf einem Wagen auf einer Kugelumlaufführung läuft, der durch einen Schrittmotor mit Getriebe über einen Zahnriemen angetrieben wird. Die Greiferleiste hat ein Schwenkgelenk 12, um das die Greiferleiste in den Richtungen eines Doppelpfeiles 12a geschwenkt werden kann, um die Druckplatte 1 einerseits vertikal der Belichtungseinheit 8 zuzuführen und andererseits die Druckplatte 1 nahezu horizontal vom Plattentisch 2 abzuholen bzw. dort wieder abzulegen. Das Hochschwenken und das Öffnen der Greiferleiste wird mit einem Motor bewerkstelligt und mit Sensoren abgefragt. Stromlos drückt eine Feder 13 die Greiferleiste zu. Die Greiferleiste hat Ausrichtanschläge für die Druckplatte 1. Zusätzlich wird über einen Sensor die Anwesenheit der Druckplatte 1 in der Greiferleiste kontrolliert.

Die Plattenführung 11 hat die Aufgabe, die Druckplatte 1 sicher in die Belichtungseinheit 8 zu führen, und sie muß die bebilderte Druckplatte 1 für das Ablegen auf den Plattentisch 2 lenken. Der Bereich der Plattenführung 11 trägt den Ladebaum 6 und ist an der Belichtungseinheit 8 befestigt. Eine mittig geschlitzte, abgewinkelte Wabenplatte bildet das Gerüst der Plattenführung 11. Da die Druckplatte 1 nur am oberen Ende von der Greiferleiste gefaßt wird, sorgen Unterdruck erzeugende Lüfter 14 in der Wabenplatte dafür, daß die Druckplatte am Ladebaum 6 entlang und anliegend in die Belichtungseinheit 8 eingeführt wird. Die Lüfter 14 sind so ausgelegt, daß die Druckplatte 1 nicht ausbeulen oder wegbiegen kann, ein Schieben der Druckplatte aber noch möglich ist und sicher gewährleistet ist. An der Plattenführung 11 ist für das Ablegen der Druckplatte 1 auf dem Plattentisch 2 eine Entladeeinrichtung angebracht. Motorgetrieben und mit zwei Sensoren überwacht, schwenken unter der Druckplatte 1 zwei Arme oder ein Plattensegment aus der Wabenplatte in Richtung des Doppelpfeils 10 und lenken so das untere Ende der Druckplatte 1 auf den Plattentisch 2. Des weiteren befinden sich zwei Sensoren an der Plattenführung 11, die das untere Ende der Druckplatte 1 erkennen und für eine Plausibilitätskontrolle herangezogen werden.

In dem gezeichneten Ausführungsbeispiel ist die Belichtungseinheit 8 eines Innentrommel-Druckplattenbelichters exemplarisch gezeigt.

In der Belichtungseinheit 8 wird die Druckplatte 1e positioniert, fixiert und bebildert. Die Belichtungseinheit 8 besteht im wesentlichen aus einem Belichtungskopf 15 mit optischen Belichtungsmitteln, einer Mulde 16 oder Innentrommelschale als Bett für die zu belichtende Druckplatte 1e in der Belichtungseinheit, in deren Achslinie der Belichtungskopf 15 angeordnet ist, einem nicht genauer erkennbaren Plattenschieber zur Positionierung der Druckplatte 1e in der Mulde 16, dessen Schieberfinger in der Mulde 15 aufragen, und einer Durchzugsstanze 17 zur Stanzung der Druckplatte 1e nach der Belichtung beim Austritt der Druckplatte 1e aus der Mulde 16.

Die Mulde 16 hat eine spezielle Gleitbeschichtung, über die die Druckplatte 1e mit Ihrer Rückseite gleiten kann. Vakuumnuten, die auf parallelen Umfangslinien der Mulde 16 an deren Innenseite verlaufen, sind so angeordnet, daß eine möglichst große Zahl unterschiedlicher Plattenformate angesaugt werden kann. Das Vakuum bzw. das Ansaugen von Luft mittels einer nicht näher dargestellten Pumpeinrichtung 18 dient zur Fixierung der Druckplatte 1e während der Belichtung und des Stanzens.

Die Stanze 17 ist auf der Platteneinlaufseite der Mulde 16 fest mit der Mulde 16 verbunden und zur Mulde 16 justiert. Für die Schiebefinger bzw. Nutensteine des Plattenschiebers und für Antriebszahnriemen des Plattenschiebers hat die Mulde zwei nicht näher dargestellte Führungsnuten in Umfangsrichtung. Die Schiebefinger werden über Zahnriemen durch Motoren getrieben und gegen den Rand der Druckplatte 1e gedrückt. Sie haben einerseits die Aufgabe, die Druckplatte 1e zum Ansaugen gegen die Muldenoberfläche zu drücken und andererseits zur Unterstützung der am Ladebaum 6 hängenden Greifeinrichtung 7 die Druckplatte 1e gegen den ausgefahrenen Stanzstempel der Stanze 17 zu drücken. Die Stanzstempel können für die Belichtung als Positionieranschläge für die Druckplatte 1e dienen, und die Druckplatte kann dann noch in angesaugtem Zustand in derselben Position unmittelbar nach der Belichtung gestanzt werden. Alternativ können aber auch geeignete Anschläge der Greifeinrichtung 7 zur Positionierung der Druckplatte 1e dienen.

Die Handhabung der Druckplatte 1 in dem dargestellten Ausführungsbeispiel eines Innentrommel-Druckplattenbelichters läuft im wesentlichen folgendermaßen ab:
Zunächst wird das Gerät eingeschaltet. Zur Initialisierung des Gerätes bzw. zur Prüfung der Betriebsbereitschaft können verschiedene Funktionen des Gerätes durchgeprobt bzw. durchgespielt und durch Sensoren überprüft werden. Ist das Gerät betriebsbereit, kann dies zum Beispiel mit einer Lampe angezeigt werden.
Der Bediener legt sodann eine neue Druckplatte 1 auf den Plattentisch 2, um das Gerät neu zu laden. Alternativ könnte bei einer automatischen Nachladung auch eine neue Druckplatte aus einem Magazin gezogen werden. Ein Sensor im Plattentisch 2 erkennt das Vorhandensein einer neuen Druckplatte und ein Plattensensor im Greifer schaltet den Lüfter 4 ein, so daß dann die Druckplatte auf einem Luftpolster schwebt. Danach können die Zentrierschieber 5 die Druckplatte sensorüberwacht zentrieren und auch die Plattenbreite ermitteln, wonach die Zentrierschieber die Druckplatte wieder freigeben.

Danach kann der weitere Ablauf automatisiert sein oder es drückt der Bediener eine Starttaste 19 für den weiteren Ablauf.

Die Greifeinrichtung 7a erkennt und ergreift die Druckplatte 1a. Der Vertikalmotor, mit dem die Greifeinrichtung 7a in die Position 7b unter Mitnahme und Anhebung der Druckplatte 1a bis in die Position 1c hochgezogen wird, wird eingeschaltet. Parallel dazu wird auch der obere Lüfter 14 eingeschaltet. Der Motor, mit dem das Greifergelenk 12 geschwenkt wird, wird gestartet, so daß er durch Eigengewicht in die vertikale Ausrichtung schwenkt. Der Lüfter 4 des Plattentisches 2 wird abgeschaltet. Der Vertikalmotor beschleunigt auf etwa 400 mm/s. Dabei fährt der Vertikalmotor durch Zählung von Encodertakten einen bestimmten Weg je nach jeweiliger Druckplattenlänge bis die Druckplatte in der Position 1c in ihrer vollen Länge in vertikaler Orientierung hängt. Dabei saugt der obere Lüfter 14 das Druckplattenende an. Mit Sensoren wird eine Auflösung von 0,1 mm für eine Positioniergenauigkeit von ± 1 mm angestrebt. Es kann beispielsweise eine Sensor für die Erkennung der Druckplattenlänge bzw. des Druckplattenendes und ein Sensor für die Erkennung der Anlage der Druckplatte 1 an der Plattenführung vorgesehen sein.

Die Wegeweiche steht in der Position 11 und der untere Lüfter 14 wird eingeschaltet. Mit dem Vertikalmotor wird dann die Druckplatte über die Position 1d bis in die Position 1e in die Mulde 16 abgesenkt und verschoben.

Der Vertikalmotor der Greifeinrichtung schiebt die Druckplatte zunächst etwa 15 mm über ihre Belichtungsposition in der Mulde hinaus, so daß hinter der Druckplatte, auch ungehindert durch die relativ schmale Greifeinrichtung, der Stanzstempel der Stanze 17 ausfahren kann. Danach wird der Stanzstempel als Anschlag für die Druckplatte und zur Abstützung der Greifeinrichtung genommen, indem die Greifeinrichtung die Druckplatte die etwa 15 mm wieder nach oben gegen den Stanzstempel zieht. Auch die Schiebefinger schieben bei nunmehr eingeschaltetem Motor mit. Erst dann wird die Druckplatte in ihrer nunmehr gefundenen Belichtungsposition 1e fixiert, indem in der Mulde unter der Druckplatte mit der Pumpeneinrichtung 18 ein Vakuum erzeugt wird. Sodann wird die Belichtung durchgeführt.

Nach der Belichtung wird der Stanzstempel der Stanze 17 ganz eingefahren und dadurch die Stanzung der belichteten Druckplatte bewirkt (Durchzugsstanze). Außerdem wird dadurch der Weg für einen Austritt der Druckplatte aus der Mulde 16 frei.

Die Pumpeneinrichtung 18 wird abgeschaltet, so daß das Vakuum in der Mulde 16 entfällt und die Druckplatte für eine Bewegung frei wird. Dafür werden der untere und der obere Lüfter 14 für eine Führung der Druckplatte eingeschaltet. Mit dem Vertikalmotor und der dadurch angetriebenen Greifeinrichtung 7 wird die Platte dann wieder in ihre obere Position 1c gezogen. Das untere Ende der Druckplatte 1c wird wiederum durch einen Sensor abgefragt. Der untere Lüfter 14 wird danach abgeschaltet.

Mit den entsprechenden Sensoren wird dann abgefragt, ob der Plattentisch 2 frei ist und die Zentrierschieber 5 auseinander gefahren sind. Die Wegeweiche wird in ihre Position 11' gebracht. Der Vertikalmotor senkt daraufhin die Greifeinrichtung 7b und die daran hängend Druckplatte 1c wieder ab und lenkt diese entsprechend der Weichenstellung auf den Plattentisch 2 über die Position 1b in die Position 1a. Bei der Umlenkung in die Waagerechte wird mit einem Schwenkmotor das Gelenk 12 der Greifeinrichtung 7 abgewinkelt. Zuvor ist schon die Wegeweiche aus der Position 11' in die Position 11 zurückgeschwenkt, sobald der untere Rand der Druckplatte in der Position 1b den Plattentisch 2 erreichte und die Lenkung der Druckplatte auf den Plattentisch 2 gewährleistet war, um den Weg für die weitere Absenkung der Greiferleiste frei zu geben.

Sobald die Druckplatte 1a auf dem Plattentisch liegt, wird dies per Sensor erkannt und die Greifeinrichtung 7a öffnet sich. Das Vorhandensein der Druckplatte 1a wird angezeigt, so daß der Bediener die fertige Druckplatte 1a entnimmt. Alternativ kann auch das automatisch geschehen.

Es soll noch einmal darauf ausdrücklich hingewiesen werden, daß ein erheblicher Vorteil der erfindungsgemäßen Vorrichtung darin besteht, daß die Druckplatte während des gesamten Prozesses in dem Belichter nicht losgelassen wird, sondern kontrolliert gehalten ist, nämlich beim Transport, beim Fixieren, beim Belichten, beim Stanzen und beim Abtransport

## Patentansprüche

1. Verfahren zur Handhabung einer Druckplatte beim Einbringen in den Belichtungsbereich einer Belichtungseinheit und / oder beim Ausbringen aus einer Belichtungseinheit eines Druckplattenbelichter,
**dadurch gekennzeichnet,**
**dass** die Druckplatte aus einer etwa waagerechten Orientierung in einem Zuführbereich von einer Greifeinrichtung ergriffen wird,
wobei die Druckplatte nur in einem Randbereich erfasst und mit der Greifeinrichtung in eine hängende Position oberhalb eines Einführungsbereichs zur Belichtungseinheit hochgezogen wird, die Druckplatte hängend abgesenkt und geleitet in eine Belichtungsposition verbracht wird und / oder die Druckplatte nach einer Belichtung auf demselben Weg zurück abgeführt wird.

2. Verfahren nach Anspruch 1,
**dadurch gekennzeichnet,**
**dass** im Zuführungsbereich unter der Druckplatte reibungsvermindernd Luft zugeführt wird.

3. Verfahren nach Anspruch 1,
**dadurch gekennzeichnet,**
**dass** die Druckplatte nach dem Belichtungsvorgang in die hängende Orientierung überführt wird und danach in eine etwa waagerechte Abführungsposition gebracht wird.

4. Verfahren nach Anspruch 1 und 3,
**dadurch gekennzeichnet,**
**dass** der Zuführungsbereich und der Abführungsbereich derselbe Bereich sind.

5. Verfahren nach Anspruch 4,
**dadurch gekennzeichnet,**
**dass** die Druckplatte auf ihrem Weg vom Zuführungsbereich über die hängende Orientierung in den Belichtungsbereich und zurück mittels einer Wegeweiche aus der hängenden Orientierung in den Zuführungsbereich oder Abführungsbereich oder in den Belichtungsbereich dirigiert wird.

6. Verfahren nach einem der vorhergehenden Ansprüche,
**dadurch gekennzeichnet,**
**dass** die Druckplatte während ihrer hängenden Orientierung eine gesteigerte Anhaftung mittels Luftabsaugung erfährt, so dass die Druckplatte noch leicht bewegt werden kann.

7. Verfahren nach einem der vorhergehenden Ansprüche,
**dadurch gekennzeichnet,**
**dass** die Druckplatte im Zuführungs- bzw. Abführungsbereich und/oder im Belichtungsbereich ausgerichtet wird.

8. Verfahren nach einem der vorhergehenden Ansprüche,
**dadurch gekennzeichnet,**
**dass** die Druckplatte nach dem Belichtungsvorgang gestanzt wird.

9. Verfahren nach Anspruch 8,
**dadurch gekennzeichnet,**
**dass** die Druckplatte in Richtung ihrer Entnahme aus der Belichtungseinheit einer Stanze zugeführt wird bzw an dieser vorbeigeführt wird.

10. Druckplattenbelichter zur Durchführung eines Verfahrens nach einem der vorhergehenden Ansprüche mit einer Vorrichtung zur Handhabung einer zu belichtenden Druckplatte beim Einbringen in den Belichtungsbereich einer Belichtungseinheit und/oder beim Ausbringen aus einer Belichtungseinheit des Druckplattenbelichters,
**dadurch gekennzeichnet,**
**dass** die Vorrichtung eine oberhalb eines Eintritts- bzw. Einführungsberichs zur Belichtungseinheit angeordnete Aufhängeeinrichtung für die Druckplatte (1) zum Führen der Druckplatte aus einem Zuführbereich über eine hängende Orientierung in eine Belichtungsposition und umgekehrt umfasst, die einen sich etwa lotrecht erstreckenden Ladebaum sowie eine am Ladebaum (6) entlang heb- und senkbare Greifeinrichtung (7) aufweist, wobei die Druckplatte (1) von der Greifeinrichtung (7) nur randseitig erfasst wird und von dieser hängend in eine Belichtungsposition oder in einen Abführbereich verbracht wird.

11. Druckplattenbelichter nach Anspruch 10,
**dadurch gekennzeichnet,**
**dass** die Aufhängeeinrichtung eine Hub-Senkeinrichtung umfaßt.

12. Druckplattenbelichter nach Anspruch 10 und 11,
**dadurch gekennzeichnet,**
**dass** die Aufhängeeinrichtung wenigstens einen Greifer (7) zum randseitigen Erfassen bzw. Umklammern der Druckplatte (1) aufweist.

13. Druckplattenbelichter nach einem der Ansprüche 10 bis 12,
**gekennzeichnet durch**
einen im Aktionsbereich der Aufhängeeinrichtung angeordneten Zuführungsbereich für die Druckplatten (1).

14. Druckplattenbelichter nach Anspruch 13,
**dadurch gekennzeichnet,**
**dass** der Zuführungsbereich eine etwa waagerecht ausgerichtete Tischplatte (2) zum Einbringen von Druckplatten umfaßt.

15. Druckplattenbelichter nach Anspruch 13 oder 14,
**dadurch gekennzeichnet,**
**dass** der Zuführungsbereich ein vorzugsweise auswechselbares und andockbares Magazin für Druckplatten (1) umfaßt.

16. Druckplattenbelichter nach Anspruch 10 und 14,
**gekennzeichnet durch**
eine Wegeweiche (11) für die Druckplatte (1) zwischen dem Aufhängebereich und dem Zuführungsbereich und der Belichtungseinheit (8).

17. Druckplattenbelichter nach einem der Ansprüche 10 bis 16,
**gekennzeichnet durch**
eine Ausrichtungseinrichtung zur Ausrichtung der Druckplatte (1).

18. Druckplattenbelichter nach einem der Ansprüche 10 bis 17,
**gekennzeichnet durch**
wenigstens eine Luftgebläse- und/oder -saugeinrichtung (4, 14, 18) zur Vorgabe eines Gleitens und/oder Haftens der Druckplatte (1) in wenigstens einem Bereich der Vorrichtung.

19. Druckplattenbelichter nach einem der Ansprüche 10 bis 18,
**gekennzeichnet durch**
eine Stanze (17) zum Stanzen der Druckplatte (1) am Ausgang der Belichtungseinheit (8).

20. Druckplattenbelichter nach einem der Ansprüche 10 bis 19,
**dadurch gekennzeichnet,**
**dass** die gesamte Vorrichtung oder Teile davon in einem Druckplattenbelichter integriert ist bzw. sind.

## Claims

1. Method of handling a printing plate upon introduction into the exposure area of an exposure unit and/or upon removal from an exposure unit of a printing plate exposure device,
**characterized by** the fact
that the printing plate is gripped by a gripping device from an essentially horizontal orientation in a infeed area and that the printing plate is gripped only in a marginal area, is lifted up, by means of the gripping device, to the exposure unit into a suspended position above an insertion region, is lowered in the suspended position and is moved in a guided manner into an exposure position and/or is removed on the same path after an exposure.

2. Method according to Claim 1,
**characterized by** the fact
that air is supplied in a friction-reducing way underneath the printing plate in the infeed area.

3. Method according to Claim 1,
**characterized by** the fact
that after the exposure, the printing plate is moved into the suspended orientation and is then moved into an approximately horizontal removal position.

4. Method according to Claims 1 and 3,
**characterized by** the fact
that the infeed area and the removal area are the same area.

5. Method according to Claim 4,
**characterized by** the fact
that on its path from the infeed area via the suspended orientation to the exposure area and back, the printing plate is directed from the suspended orientation into the infeed area or the removal area or the exposure area by means of a switch.

6. Method according to any one of the preceding claims,
**characterized by** the fact
that while in the suspended orientation, the printing plate experiences an increased adhesion due to air suction so that the printing plate can still be moved easily.

7. Method according to any one of the preceding claims,
**characterized by** the fact
that the printing plate is aligned in the infeed and removal area, respectively, and/or in the exposure area.

8. Method according to any one of the preceding claims,
**characterized by** the fact
that the printing plate is punched after the exposure.

9. Method according to Claim 8,
**characterized by** the fact
that the printing plate is moved from the exposure unit to a punching device or past the latter, respectively, in the direction of its removal.

10. Printing plate exposure device for carrying out a method according to any one of the preceding claims, including a device for handling a printing plate to be exposed while it is being introduced into the exposure area of an exposure unit and/or removed from an exposure unit of the printing plate exposure device, **characterized by** the fact
that the device comprises a suspension device for the printing plate (1) arranged above an entry or introduction area of the exposure unit for guiding the printing plate (1) from an infeed area via a suspended orientation to an exposure position and vice versa, the suspension device having an essentially vertical load arm and a gripping device (7) capable of being lifted and lowered along the load arm (6) and gripping the printing plate (1) only in a marginal area to move the printing plate (1) into an exposure position or into a removal area in a suspended state.

11. Printing plate exposure device according to Claim 10,
**characterized by** the fact
that the suspension device includes a lifting and lowering device.

12. Printing plate exposure device according to Claims 10 and 11,
**characterized by** the fact
that the suspension device includes at least one gripper (7) for gripping or grasping the printing plate (1) in a marginal area.

13. Printing plate exposure device according to any one of claims 10 to 12,
**characterized by**
an infeed area for the printing plates (1) arranged in the area of action of the suspension device.

14. Printing plate exposure device according to Claim 13,
**characterized by** the fact
that the infeed area comprises an essentially horizontal table plate (2) for introducing printing plates.

15. Printing plate exposure device according to Claim 13 or 14,
**characterized by** the fact
that the infeed area comprises a magazine for printing plates (1) which is preferably exchangeable and connectable.

16. Printing plate exposure device according to Claims 10 and 14
**characterized by**
a switch (11) for the printing plate (1) between the suspension area and the infeed area and the exposure unit (8).

17. Printing plate exposure device according to any one of claims 10 to 18,
**characterized by**
an alignment device for aligning the printing plate (1).

18. Printing plate exposure device according to any one of claims 10 to 17,
**characterized by**
at least one air blower and/or suction device (4, 14, 18) for ensuring a sliding and/or adhering of the printing plate (1) in at least one area of the device.

19. Printing plate exposure device according to any one of claims 10 to 18,
**characterized by**
a punching device (17) for punching the printing plate (1) at the exit of the exposure unit (8).

20. Printing plate exposure device according to any one of claims 10 to 19,
**characterized by** the fact
that the entire device or parts thereof is or are integrated in a printing plate exposure device.

## Revendications

1. Procédé pour la manipulation d'une plaque d'impression pour l'amenée dans la zone d'exposition d'une unité d'exposition et/ou la sortie d'une unité d'exposition d'un dispositif d'exposition de plaque d'impression,
**caractérisé en ce que** la plaque d'impression est saisie depuis une orientation sensiblement horizontale dans une zone d'amenée par un dispositif de préhension,
la plaque d'impression n'étant saisie que dans une zone de bordure et étant tirée vers le haut par le dispositif de préhension dans une position suspendue au-dessus d'une zone d'insertion en direction de l'unité de développement, la plaque d'impression étant abaissée et dirigée dans une position d'exposition sur le même chemin après une exposition.

2. Procédé selon la revendication 1, **caractérisé en ce que** l'air est amené dans la zone d'amenée sous la plaque d'impression pour réduire la friction.

3. Procédé selon la revendication 1, **caractérisé en ce que** la plaque d'impression est transportée après l'opération d'exposition dans une orientation suspendue et est ensuite amenée dans une position horizontale de sortie.

4. Procédé selon la revendication 1 et 3, **caractérisé en ce que** la zone d'amenée et la zone de sortie sont la même zone.

5. Procédé selon la revendication 4, **caractérisé en ce que** la plaque d'impression est dirigée sur son trajet depuis la zone d'amenée en orientation suspendue dans la zone d'exposition et de retour au moyen d'un aiguillage depuis l'orientation suspendue dans la zone d'amenée ou dans la zone d'exposition.

6. Procédé selon l'une des revendications précédentes, **caractérisé en ce que**
la plaque d'impression subit pendant son orientation suspendue une adhérence croissante par aspiration d'air de sorte que la plaque d'impression peut être encore un peu déplacée.

7. Procédé selon l'une des revendications précédentes, **caractérisé en ce que** la plaque d'impression est orientée dans la zone d'amenée respectivement de sortie et/ou dans la zone d'exposition.

8. Procédé selon l'une des revendications précédentes, **caractérisé en ce que** la plaque d'impression est découpée après l'opération d'exposition.

9. Procédé selon la revendication 8, **caractérisé en ce que** la plaque d'impression est amenée dans la direction de son retrait d'une unité d'exposition d'une poinçonneuse respectivement est déplacée le long de cette dernière.

10. Dispositif d'exposition de plaque d'impression pour la mise en oeuvre d'un procédé selon l'une des revendications précédentes, avec un dispositif pour la manipulation d'une plaque d'impression à exposer lors de l'amenée dans la zone d'exposition d'une unité d'exposition et/ou la sortie d'une unité d'exposition d'un dispositif d'exposition de plaque d'impression,
**caractérisé en ce que** le dispositif comprend un dispositif de suspension disposé au-dessus de la zone d'entrée et de sortie de l'unité d'exposition pour la plaque d'impression (1) en vue du guidage de la plaque d'impression depuis une zone d'amenée par une orientation suspendue dans une position d'exposition et inversement, dispositif qui présente un arbre de chargement s'étendant verticalement ainsi qu'un dispositif de préhension (7) élevable et abaissable le long de l'arbre de chargement (6), la plaque d'impression (1) n'étant saisie que sur le bord par le dispositif de préhension (7) et étant amenée par ce dernier en suspension dans une position d'exposition ou dans une zone de sortie.

11. Dispositif d'exposition de plaque d'impression selon la revendication 10, **caractérisé en ce que** le dispositif de suspension comprend un dispositif d'abaissement et de levage.

12. Dispositif d'exposition de plaque d'impression selon la revendication 10 ou 11, **caractérisé en ce que** le dispositif de suspension présente au moins une pince (7) pour saisir sur le bord respectivement entourer la plaque d'impression (1).

13. Dispositif d'exposition de plaque d'impression selon l'une des revendications 10 à 12, **caractérisé par** une zone d'amenée (1) disposée dans la zone d'action du dispositif de suspension pour les plaques d'impression.

14. Dispositif d'exposition de plaque d'impression selon la revendication 13, **caractérisé en ce que** la zone d'amenée comprend une plaque formant plateau orientée horizontalement (2) pour l'amenée de plaques d'impression.

15. Dispositif d'exposition de plaque d'impression selon la revendication 13 ou 14, **caractérisé en ce que** la zone d'amenée comprend un magasin de préférence échangeable et dockable pour des plaques d'impression (1).

16. Dispositif d'exposition de plaque d'impression selon la revendication 10 ou 14, **caractérisé par** un aiguillage (11) pour la plaque d'impression (1) entre la zone de suspension et la zone d'amenée et l'unité d'exposition (8).

17. Dispositif d'exposition de plaque d'impression selon l'une des revendications 10 à 16, **caractérisé par** un dispositif d'orientation pour l'orientation de la plaque d'impression (1).

18. Dispositif d'exposition de plaque d'impression selon l'une des revendications 10 à 17, **caractérisé par** au moins un dispositif d'aspiration et/ou de soufflage d'air (4, 14, 16) pour la détermination d'un glissement et/ou une adhérence de la plaque d'impression (1 dans au moins une zone du dispositif.

19. Dispositif d'exposition de plaque d'impression selon l'une des revendications 10 à 18, **caractérisé par** une poinçonneuse (17) pour poinçonner la plaque d'impression () à la sortie de l'unité d'exposition (8).

20. Dispositif d'exposition de plaque d'impression selon l'une des revendications 10 à 19, **caractérisé en ce que** l'ensemble du dispositif ou des parties de ce dernier est/sont intégré(es) dans un dispositif d'exposition de plaque d'impression.
